# EUROPEAN PATENT APPLICATION

(11) **EP 4 190 945 A1**
(43) Date of publication of application: **07.06.2023**
(21) Application number: 21211706.3
(22) Date of filing: 01.12.2021
(51) Int. Cl.: C25D 17/00, H05K 3/00, H05K 3/42, H01L 21/48, H01L 23/495

(54) **METHOD OF MANUFACTURING A METAL-COATED WORKPIECE, METAL-COATED WORKPIECE, AND MANUFACTURING SYSTEM**

(71) Applicant: Rohde & Schwarz GmbH & Co. KG, 81671 München (DE)
(72) Inventor: Roehrl, Franz, 81671 München (DE)
(74) Representative: Prinz & Partner mbB

(57) **Abstract**

A method of manufacturing a metal-coated workpiece, particularly a metal-coated electronic component, is described. A method of manufacturing a metal-coated workpiece (12), particularly a metal-coated electronic component, the method comprising the following steps:
- providing a substrate (22) to be coated,
- coating the substrate (22) with a first metal on at least one side of the substrate, thereby creating a mask (26) that partially covers the at least one side of the substrate (22) such that a workpiece (44) is obtained which comprises the substrate (22) and the mask (26), wherein the mask (26) comprises opaque portions that are impermeable to light, thereby protecting the substrate (22), and wherein the mask comprises translucent portions (46) that are permeable to light;
- applying a light source (32) to the workpiece (44) on at least the side of the substrate (22) covered by the mask (26), wherein the light source (32) emits light (34) having a predetermined wavelength and/or a predetermined power over the entire side of the substrate (22) that is at least partially covered by the mask (26), such that apertures are formed in the substrate (22) at portions not covered by the mask (26), whereas the mask (26) is left intact by the light (34); and
- coating the workpiece (44) with a second metal that at least partially covers the substrate (22) and/or the mask (26), thereby obtaining a metal-coated workpiece (12).

Further, a metal-coated workpiece (12) and a manufacturing system (10) for manufacturing a metal-coated workpiece (12) are described.

## Description

The present invention generally relates to a method of manufacturing a metal-coated workpiece. The present invention further relates to a metal-coated workpiece and to a manufacturing system for manufacturing a metal-coated workpiece.

In many different applications, particularly in the field of electronics, metal components having a structure with apertures are used.

There is a variety of different known techniques that can be used in order to manufacture such metal components, for example electroforming, etching, laser cutting, water jet cutting, stamping, and wire electrical discharge machining.

However, the known techniques either allow for manufacturing large quantities with reduced precision or for manufacturing smaller quantities with enhanced precision.

Thus, the object of the present invention is to provide a method of manufacturing a metal-coated workpiece that allows for manufacturing large quantities with high precision.

According to the invention, the problem is solved by a method of manufacturing a metal-coated workpiece, particularly a metal-coated electronic component. The method comprises the following steps:
- providing a substrate to be coated,
- coating the substrate with a first metal on at least one side of the substrate, thereby creating a mask that partially covers the at least one side of the substrate such that a workpiece is obtained which comprises the substrate and the mask, wherein the mask comprises opaque portions that are impermeable to light, thereby protecting the substrate, and wherein the mask comprises translucent portions that are permeable to light;

- applying a light source to the workpiece on at least the side of the substrate covered by the mask, wherein the light source emits light having a predetermined wavelength and/or a predetermined power over the entire side of the substrate that is at least partially covered by the mask, such that apertures are formed in the substrate at portions not covered by the mask, whereas the mask is left intact by the light; and
- coating the workpiece with a second metal that at least partially covers the substrate and/or the mask, thereby obtaining a metal-coated workpiece.

In the state of the art, the manufactured workpieces usually are solid metal workpieces, i.e. the workpieces are manufactured from a solid piece of metal.

The invention is based on the idea to provide a (non-metal) substrate as a basis for manufacturing the metal-coated workpiece. The substrate is coated with the metal mask. The metal mask serves as an optical aperture for the selective removal of material from the substrate by means of the light source. The resulting workpiece is then coated with the second metal, thereby obtaining the final metal-coated workpiece. The final metal-coated workpiece can be used for producing electronic devices.

The second metal covers the substrate and/or the mask at least partially, particularly completely. Thus, a layer of the second metal is formed on portions of the surface of the workpiece or on the complete surface of the workpiece, particularly all surfaces of the workpiece. In other words, the second metal may partly or fully cover the substrate and/or the mask.

It has turned out that the method according to the present invention can be used for manufacturing metal-coated workpieces having fine structures, particularly apertures, with a particularly high precision and with well-defined edges without burrs.

In fact, the method according to the present invention allows for manufacturing the metal-coated workpieces with a tolerance of less than 10 percent.

This is due to the fact that the metal mask can be thin compared to the overall thickness of the final metal-coated workpiece. This allows for fine structures to be incorporated into the metal mask.

Accordingly, a precise optical aperture is provided for the treatment of the workpiece with the light source.

In fact, it has turned out that the method according to the present invention allows for manufacturing metal-coated workpieces that have narrow apertures and/or narrow crosspieces compared to the overall thickness of the metal-coated workpiece.

Moreover, it has turned out that the method according to the present invention is suitable for producing the metal-coated workpiece in large quantities, i.e. on an industrial scale.

Further, different geometries of the metal-coated workpiece can easily be obtained by adapting the layout of the mask, which can be adapted in a fast and cost-efficient manner.

The first metal may be copper or any other suitable metal.

The second metal may be copper or any other suitable metal.

Particularly, the metal-coated workpiece may be a metal-coated electronic component, for instance a metal-coated electronic component for an electronic device. Accordingly, the metal-coated workpiece may have an overall thickness of several µm up to several mm. Particularly, the metal-coated workpiece may have an overall thickness between 20 µm and 1 mm, for example between 50 µm and 500 µm.

According to an aspect of the present invention, the first metal and the second metal are the same metal, particularly copper. As the first metal and the second metal are the same metal, thermal tensions inside the workpiece are reduced, for example if the metal-coated workpiece is heated locally or completely.

According to a further aspect of the present invention, the light source is a laser, particularly a CO₂-laser. In general, lasers are available with a large variety of wavelengths and powers, such that the suitable laser can easily be chosen for manufacturing the particular metal-coated workpiece at hand. The laser ensures a precise processing during the manufacturing process of the metal-coated workpiece.

It has turned out that a CO₂ laser is particularly suitable for the method according to the present invention, as the wavelength of the CO₂ laser is such that the metal mask is left intact. Moreover, CO₂ lasers are available in a large variety of different powers, such that a suitable CO₂ laser is available for any type of metal-coated workpiece to be manufactured.

In an embodiment of the present invention, the mask is provided on the substrate by etching a metal layer covering the substrate, and/or by electroforming of the mask onto the substrate. The technique for providing the mask on the substrate may be chosen based on the particular requirements.

The etching technique is particularly suitable for producing large quantities of the metal-coated workpiece. Thus, if particularly large quantities are required, then the mask may be provided by etching the metal layer covering the substrate.

The electroforming technique allows for a particularly high precision of the mask and thus of the metal-coated workpiece. Hence, if a particularly high precision is required, then the mask may be provided by electroforming of the mask onto the substrate.

In a further embodiment of the present invention, the substrate consists of a printed circuit board (PCB) material. For example, the substrate may comprise or even consist of a fiber-reinforced material, such as a fiber-reinforced synthetic material. Particularly, the substrate may comprise a bondable structure. Hence, the substrate may be used for subsequent bonding processes.

According to another aspect of the present invention, the metal-coated workpiece is a lead frame or an array of lead frames. The metal-coated workpiece may be a lead-frame for a chip or for other electronic components.

Therein and in the following, an "array" is understood to denote a metal-coated workpiece comprising several smaller metal-coated sub-workpieces that are still interconnected, particularly wherein the smaller sub-workpieces may be arranged in a regular pattern. The respective metal-coated sub-workpieces may also relate to electronic components.

If the metal-coated workpiece is an array of lead frames, the array of lead frames may be cut and/or stamped such that the individual lead frames are separated from each other.

However, it is to be understood that the metal-coated workpiece may be any other array of smaller metal-coated sub-workpieces.

Particularly, the workpiece is coated with the second metal by means of a Galvanic coating process. This way, a particularly smooth surface of the metal-coated workpiece is obtained, as the metal-coated workpiece is uniformly coated with the second metal.

A thickness of the mask may be smaller than or equal to 90% of a thickness of the substrate, particularly smaller than or equal to 75% of the thickness of the substrate, for example smaller than or equal to 60% of the thickness of the substrate. Accordingly, the mask is considerably thinner than the substrate. This is particularly advantageous if the mask is formed by etching a metal layer provided on the substrate, as the mask can be manufactured very precisely due to the relatively small thickness of the metal layer provided on the substrate.

In an embodiment of the present invention, two masks are provided on opposite sides of the substrate, wherein the two masks each comprise opaque portions and translucent portions. Accordingly, the two masks together determine the final structure of the metal-coated workpiece, as the two masks both are left intact by the light emitted by the light source.

For example, if opaque portions of the two masks are provided on immediately opposite surface areas of the substrate, these areas of the substrate are left completely intact by the light emitted by means of the light source, as these areas are protected by means of the opaque portions.

If translucent portions of the two masks are provided on immediately opposite surface areas of the substrate, an aperture is formed in the workpiece, as the light emitted by the light source completely removes the substrate in the corresponding regions of the substrate.

If a translucent portion of the mask facing the light source is provided immediately opposite of an opaque portion of the other mask, a recess is formed in the substrate, as the substrate is removed in the region corresponding to the translucent portion of the mask facing the light source. However, the other mask is left intact by the light emitted by the light source, such that no complete aperture through the workpiece is formed.

Accordingly, after applying the light source to the workpiece, a workpiece having a complex structure comprising apertures and/or recesses can be obtained. This complex structure is maintained after coating the workpiece with the second metal, such that the metal-coated workpiece may also have a complex structure comprising apertures and/or recesses.

In a further embodiment of the present invention, the opaque portions and the translucent portions of a first one of the two masks form a first pattern, wherein the opaque portions and the translucent portions of a second one of the two masks form a second pattern, and wherein the first pattern and the second pattern are different from each other.

Accordingly, there are portions of the substrate that are covered by an opaque portion of the first one of the two masks and by a translucent portion of the second one of the two masks. On the other hand, there are portions of the substrate that are covered by a translucent portion of the first one of the two masks and by an opaque portion of the second one of the two masks. Thus, the metal-coated workpiece may have a complex structure comprising apertures and/or recesses, as already explained above.

According to a further aspect of the present invention, the opaque portions and the translucent portions of a first one of the two masks form a first pattern, wherein the opaque portions and the translucent portions of a second one of the two masks form a second pattern, and wherein the first pattern and the second pattern are equal to each other. In other words, each portion of the substrate either is covered by opaque portions of both masks or is covered by translucent portions of both masks. Accordingly, when the light source is applied to the workpiece, the individual portions of the substrate are either completely left intact or completely removed such that apertures are formed in the workpiece, respectively.

A further aspect of the present invention provides that the metal-coated workpiece is coated with at least a third metal at least partially, particularly wherein the third metal is different from the second metal. Thus, the metal-coated workpiece is at least partially coated with at least one further metal layer that is formed on portions of the surface of the metal-coated workpiece or on the complete surface of the metal-coated workpiece.

The third metal may, for example, be gold, silver, palladium, tin, or any other suitable metal.

Moreover, the second metal may also be gold, silver, palladium, tin, or any other suitable metal.

It is also conceivable that the metal-coated workpiece is coated with several further metal layers. Each metal layer may partially or completely cover the metal-coated workpiece, e.g. the substrate and/or the mask.

Generally, a sandwich-like structure may be provided, which consists of several (different) metal layers, in particular wherein one of these layers is associated with the second metal.

Thus, a desired surface finish can be obtained, for example a bondable surface finish.

In an embodiment of the present invention, the metal-coated workpiece comprises apertures extending between opposite sides of the metal-coated workpiece. Alternatively or additionally, the metal-coated workpiece may comprise recesses on at least one side of the metal-coated workpiece. Thus, the metal-coated workpiece having a complex structure with apertures and/or recesses can be manufactured by means of the method according to the present invention.

According to an aspect of the present invention, at least one of the apertures has a diameter that is smaller than a thickness of the metal-coated workpiece, particularly smaller than 75% of the thickness of the metal-coated workpiece, for example smaller than 50% of the thickness of the metal-coated workpiece. Thus, apertures having a diameter that is considerably smaller than the thickness of the metal-coated workpiece can be manufactured by means of the method according to the present invention. This may not be possible by means of known techniques that manufacture the workpiece from a solid piece of metal.

According to the invention, the problem further is solved by a metal-coated workpiece obtainable by a method described above. Regarding the advantages and further properties of the metal-coated world peace, reference is made to the explanations given above with respect to the method, which also hold for the metal-coated workpiece and vice versa.

According to the invention, the problem further is solved by a manufacturing system for manufacturing a metal-coated workpiece, particularly a metal-coated electronic component. The manufacturing system comprises a mask-forming device, an illumination device, and a coating device. The mask-forming device is configured to provide a mask on at least one side of a substrate, wherein the mask consists of a first metal. The mask partially covers the at least one side of the substrate such that a workpiece is obtained which comprises the substrate and the mask. The mask comprises opaque portions that are impermeable to light, thereby protecting the substrate, and translucent portions that are permeable to light. The illumination device is configured to apply a light source to the workpiece on at least the side of the substrate covered by the mask. The light source is configured to emit light having a predetermined wavelength and/or a predetermined power over the entire side of the substrate that is at least partially covered by the mask, such that apertures are formed in the substrate at portions not covered by the mask, whereas the mask is left intact by the light. The coating device is configured to coat the workpiece with a second metal, thereby obtaining a metal-coated workpiece.

Particularly, the manufacturing system is configured to perform the method of manufacturing a metal-coated workpiece described above.

Regarding the advantages and further properties of the manufacturing system, reference is made to the explanations given above with respect to the manufacturing method, which also hold for the manufacturing system and vice versa.

The foregoing aspects and many of the attendant advantages of the claimed subject matter will become more readily appreciated as the same become better understood by reference to the following detailed description, when taken in conjunction with the accompanying drawings, wherein:
- Figure 1 schematically shows a manufacturing system according to the present invention;
- Figure 2 shows a flow chart of a method of manufacturing a metal-coated workpiece according to the present invention;
- Figures 3a to 3c schematically show a cross-section of the metal-coated workpiece during different steps of the method of Figure 2;
- Figure 4 shows an example of a manufactured metal-coated workpiece; and
- Figure 5 shows a portion of the metal-coated workpiece of Figure 4 in more detail.

The detailed description set forth below in connection with the appended drawings, where like numerals reference like elements, is intended as a description of various embodiments of the disclosed subject matter and is not intended to represent the only embodiments. Each embodiment described in this disclosure is provided merely as an example or illustration and should not be construed as preferred or advantageous over other embodiments. The illustrative examples provided herein are not intended to be exhaustive or to limit the claimed subject matter to the precise forms disclosed.

For the purposes of the present disclosure, the phrase "at least one of A, B, and C", for example, means (A), (B), (C), (A and B), (A and C), (B and C), or (A, B, and C), including all further possible permutations when more than three elements are listed. In other words, the term "at least one of A and B" generally means "A and/or B", namely "A" alone, "B" alone or "A and B".

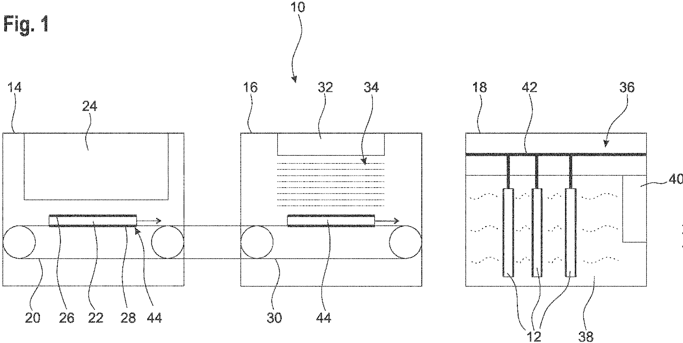

Figure 1 schematically shows a manufacturing system 10 for manufacturing a metal-coated workpiece 12, particularly a metal-coated electronic component.

The metal-coated workpiece 12 may be a lead frame or an array of lead frames. Particularly, the metal-coated workpiece 12 may be a lead-frame for a chip, such as a computer chip, or for other electronic components.

The metal-coated workpiece may be established as any other array of electronic components.

Therein and in the following, an "array" is understood to denote a metal-coated workpiece comprising several smaller metal-coated sub-workpieces that are still interconnected, particularly wherein the smaller sub-workpieces are arranged in a regular pattern.

The manufacturing system 10 comprises a mask-forming device 14, an illumination device 16, and a coating device 18.

It is noted that while the manufacturing system 10 is depicted to comprise three different devices 14, 16, 18 in Figure 1, the mask-forming device 14, the illumination device 16, and/or the coating device 18 may also be integrated into a single device.

Likewise, the mask-forming device 14, the illumination device 16 and/or the coating device 18 may comprise a plurality of sub-devices that are configured to perform individual steps of the method of manufacturing the metal-coated workpiece 12 described below in more detail.

In the shown embodiment, the mask-forming device 14 comprises conveying means 20 for conveying a substrate 22, and mask-forming means 24 for providing at least a first mask 26 onto the substrate 22.

Optionally, the mask-forming means 24 may also be configured to provide a second mask 28 onto the substrate 22 on a side of the substrate 22 that is opposite to the first mask 26.

The illumination device 16 comprises conveying means 30 and a light source 32, wherein the light source 32 is configured to emit light 34 having a predefined wavelength and/or power.

Particularly, the light source 32 may be established as a CO₂ laser.

The coating device 18 comprises coating means 36, wherein the coating means 36 may correspond to components for galvanizing workpieces.

Particularly, the coating means 36 may comprise a galvanization tank 38, a metal anode 40, and connecting means 42 for holding and applying an electrical current to one or several workpieces to be galvanized.

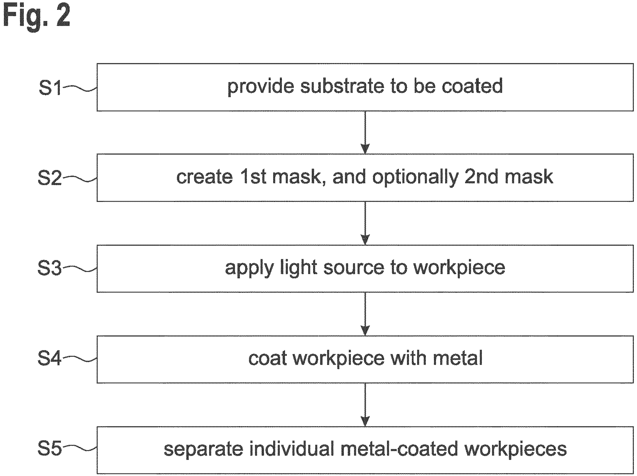

In general, the manufacturing system 10 is configured to perform a method of manufacturing the metal-coated workpiece 12 that is described in the following with reference to Figure 2.

The substrate 22 to be coated is provided and transferred to the mask-forming device 14 (step S1).

In general, the substrate 22 may consist of any suitable non-metal material, combination of non-metal materials, or combination of non-metal materials and metal materials.

Particularly, the substrate 22 consists of a printed circuit board (PCB) material. For example, the substrate 22 may comprise or even consist of a fiber-reinforced material, such as a fiber-reinforced synthetic material.

The substrate 22 is coated with a first metal, particularly copper, on at least one side of the substrate 22 by the mask-forming means 24, thereby creating at least the first mask 26 (step S2), particularly the first mask 26 and the second mask 28.

Generally, the substrate 22 may be coated on two (opposite) sides, particularly all sides.

Thereby, a workpiece 44 is obtained that comprises the substrate 22, the first mask 26 and, optionally, the second mask 28.

Without restriction of generality, it is assumed in the following that both the first mask 26 and the second mask 28 are provided on the substrate 22.

The first mask 26 and the second mask 28 may be created on the substrate 22 by means of an etching technique.

Thus, full layers of the first metal may be provided on both sides of the substrate 22. Afterwards, certain portions of the metal layers may be removed by means of any suitable etching technique, such that the first mask 26 and the second mask 28 are created.

Alternatively, the first mask 26 and the second mask 28 may be formed on the substrate 22 by means of an electroforming technique.

It is also conceivable that one of the first mask 26 and the second mask 28 is created by means of an etching technique, while the other one of the first mask 26 and the second mask 28 is formed on the substrate 22 by means of an electroforming technique.

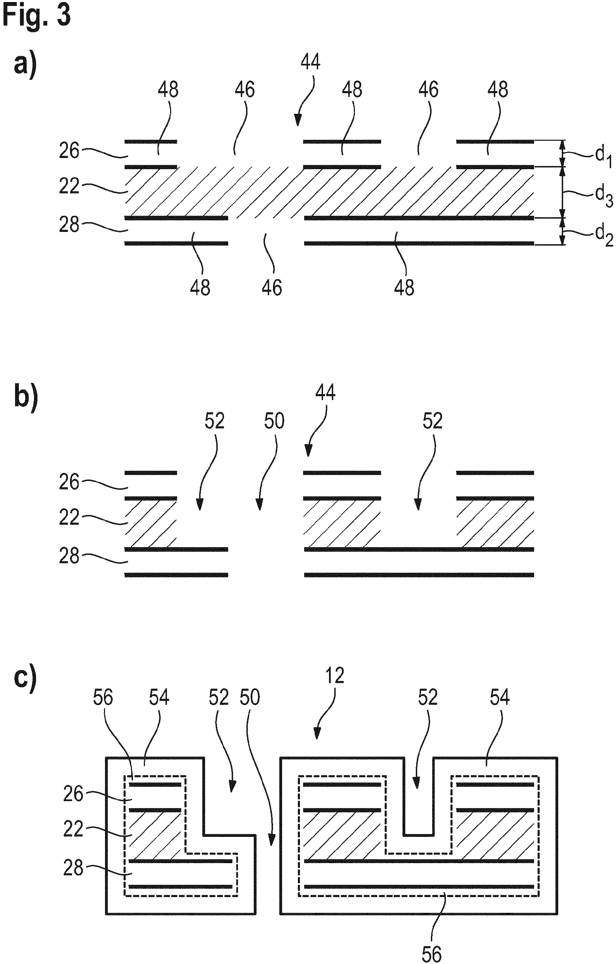

The result of step S2 is illustrated in Figure 3a, which shows a cross section of the workpiece 44 comprising the substrate 22, the first mask 26, and the second mask 28. In the shown embodiment, the masks 26, 28 are applied on opposite sides of the substrate 22.

As can clearly be seen in Figure 3a, the first mask 26 and the second mask 28 each comprise translucent portions 46 and opaque portions 48, respectively.

In the translucent portions 46, the first metal does not cover the substrate 22, such that light from an external light source can reach the substrate 22.

In the opaque portions 48, the first metal covers the substrate 22, such that light from an external light source is blocked from reaching the substrate 22.

As is further shown in Figure 3a, the first mask 26 has a first thickness d₁, the second mask 28 has a second thickness d₂, and the substrate 22 has a third thickness d₃.

In general, the first thickness d₁ and the second thickness d₂ may be smaller than the third thickness d₃, respectively. Particularly, the first thickness d₁ and the second thickness d₂ may be equal.

A respective thickness of the masks 26, 28 may be smaller than or equal to 90% of a thickness of the substrate 22, particularly smaller than or equal to 75% of the thickness of the substrate 22, for example smaller than or equal to 60% of the thickness of the substrate 22.

As an example, the first thickness d₁ and the second thickness d₂ may be between 20 and 60 µm, particularly between 30 and 50 µm, for example approximately equal to 40 µm.

However, it is to be understood that the first thickness d₁ and the second thickness d₂ may have any other suitable value depending on the application of the metal-coated workpiece 12.

The third thickness d₃ may be between 40 and 80 µm, particularly between 50 and 70 µm, for example approximately 60 µm.

The workpiece 44 comprising the substrate 22, the first mask 26, and the second mask 28 is transferred to the illumination device 16, e.g. manually or rather automatically in case of an automatic manufacturing process, for instance an automatic production line.

The light source 32 emits the light 34 having the predefined wavelength and/or the predefined power such that the whole side of the workpiece 44 covered by the first mask 26 is subjected to the emitted light 34 (step S3).

Regions of the substrate 22 not covered by the first mask 26 are removed due to the light 34, while the metal masks 26, 28 are left intact by the light 34.

Therein, the first mask 26 serves as an optical aperture for the selective removal of material from the substrate 22 by means of the light 34 emitted by the light source 32.

The result of step S3, particularly the removed regions of the substrate 22, is illustrated in Figure 3b which shows a cross section of the workpiece 44 after the light source 32 has been applied.

As is clearly visible in Figure 3b, apertures 50 and/or recesses 52 are formed in certain regions of the workpiece 44, while other regions of the workpiece 44 are left completely intact.

More precisely, regions of the workpiece 44 covered by opaque portions 48 of the first mask 26 are left completely intact.

In regions of the workpiece 44 that are "covered"/associated by the translucent portions 46 of both masks 26, 28, the apertures 50 are formed in the workpiece 44, as the light 34 emitted by the light source 32 completely removes the substrate 22 in the corresponding areas of the substrate 22.

In regions of the workpiece 44 that are covered by a translucent portion 46 of the first mask 26 and by an opaque portion 48 of the second mask 28, the recesses 52 are formed in the workpiece 44, as the light 34 emitted by the light source 32 completely removes the substrate 22 in the corresponding areas of the substrate 22, but the second mask 28 is left intact.

The workpiece 44 comprising the substrate 22, the first mask 26, the second mask 28, as well as the apertures 50 and/or recesses 52 is transferred to the coating device 18, e.g. manually or rather automatically in a fully automatic production line.

The workpiece 44 is coated with a second metal, thereby obtaining the metal-coated workpiece 12 (step S4), which is shown in Figure 3c.

In other words, a metal layer 54 is formed on portions of the surface of the workpiece 44 or on the complete surface of the workpiece 44.

In order to form the metal layer 54 on the workpiece 44, the workpiece 44 or several workpieces 44 are attached to the connecting means 42 and submerged in the galvanization tank 38 that is filled with a suitable solution.

Optionally, a suitable intermediary layer 56 may be applied to the workpiece 44 before submerging the workpiece 44 in the galvanization tank 38.

A voltage is applied to the workpiece 44 via the connecting means 42 and to the metal anode 40. Due to the applied voltage, the metal of the metal anode 40 goes into solution and deposits on the workpiece 44, thereby forming the metal layer 54.

Particularly, the metal anode 40 may be a copper anode, such that the metal layer 54 consists of copper.

The result of step S4 is illustrated in Figure 3c, which shows a cross section of the workpiece 44 after the coating with the second metal.

As is clearly visible in Figure 3c, the workpiece 44 is uniformly coated with the metal layer 54.

The complex structure of the workpiece 44 is maintained, such that the metal-coated workpiece 12 also comprises apertures 50 and/or recesses 52.

A thickness of the metal layer 54 may be approximately equal to the thicknesses of the masks 26, 28.

The thickness of the metal layer 54 may be between 20 and 60 µm, particularly between 30 and 50 µm, for example approximately equal to 40 µm.

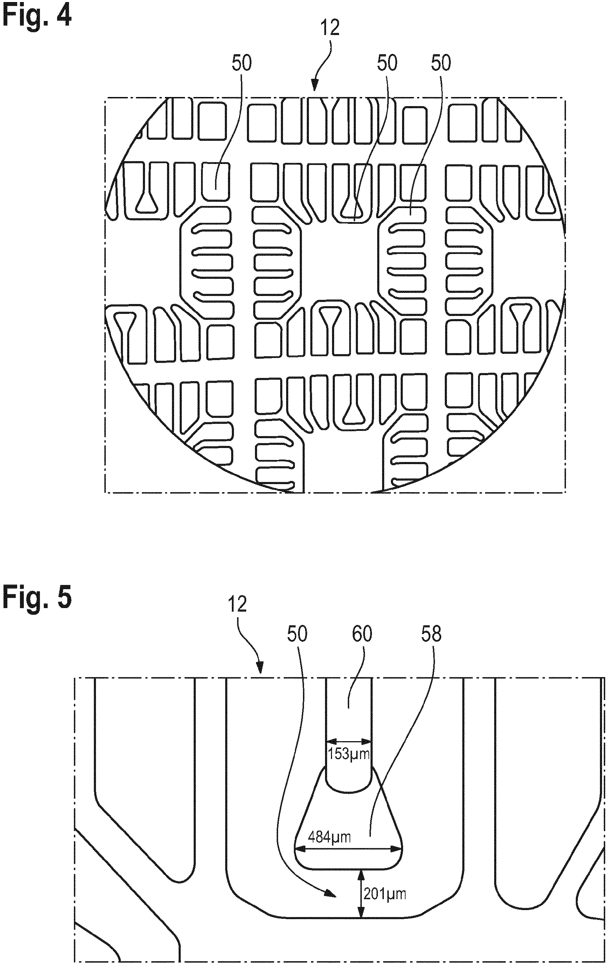

Figure 4 shows an exemplary metal-coated workpiece 12 resulting from the method described above.

In this example, the metal-coated workpiece 12 is an array of lead frames.

As is clearly visible in Figure 4, the metal-coated workpiece 12 has a complex structure comprising a plurality of precisely formed apertures 50 without burrs.

Optionally, the metal-coated workpiece 12 may be coated with at least a third metal at least partially, particularly wherein the third metal is different from the second metal.

Thus, the metal-coated workpiece 12 is at least partially coated with at least one further metal layer that is formed on portions of the surface of the metal-coated workpiece 12 or on the complete surface of the metal-coated workpiece 12.

The third metal may, for example, be gold, silver, palladium, tin, or any other suitable metal.

It is also conceivable that the metal-coated workpiece 12 is coated with several further metal layers, particularly in a sandwich-like structure, wherein each metal layer may partially or completely cover the metal-coated workpiece 12.

If the metal-coated workpiece 12 is an array of smaller workpieces, the array may be cut and/or stamped such that the individual smaller workpieces are separated from each other (step S5).

Figure 5 shows a zoomed-in view of the metal-coated workpiece 12 of Figure 4.

In Figure 5, some exemplary dimensions of portions of the metal-coated workpiece are given. In this particular example, the metal-coated workpiece comprises an end portion 58 with a diameter of 484 µm, a crosspiece 60 being connected to the end portion 58 with a diameter of 153 µm, and an aperture 50 with a diameter of 201 µm.

However, it is to be understood that the metal-coated workpiece 12 may have any other structure with any other dimensions.

Particularly, thin apertures 50 can be created by means of the method described above.

Thus, apertures 50 having a diameter that is smaller than a thickness of the metal-coated workpiece 12, particularly smaller than 75% of the thickness of the metal-coated workpiece 12, for example smaller than 50% of the thickness of the metal-coated workpiece 12 are possible.

Certain embodiments disclosed herein, particularly the respective module(s) and/or unit(s), utilize circuitry (e.g., one or more circuits) in order to implement standards, protocols, methodologies or technologies disclosed herein, operably couple two or more components, generate information, process information, analyze information, generate signals, encode/decode signals, convert signals, transmit and/or receive signals, control other devices, etc. Circuitry of any type can be used.

In an embodiment, circuitry includes, among other things, one or more computing devices such as a processor (e.g., a microprocessor), a central processing unit (CPU), a digital signal processor (DSP), an application-specific integrated circuit (ASIC), a field-programmable gate array (FPGA), a system on a chip (SoC), or the like, or any combinations thereof, and can include discrete digital or analog circuit elements or electronics, or combinations thereof. In an embodiment, circuitry includes hardware circuit implementations (e.g., implementations in analog circuitry, implementations in digital circuitry, and the like, and combinations thereof).

In an embodiment, circuitry includes combinations of circuits and computer program products having software or firmware instructions stored on one or more computer readable memories that work together to cause a device to perform one or more protocols, methodologies or technologies described herein. In an embodiment, circuitry includes circuits, such as, for example, microprocessors or portions of microprocessor, that require software, firmware, and the like for operation. In an embodiment, circuitry includes one or more processors or portions thereof and accompanying software, firmware, hardware, and the like.

The present application may reference quantities and numbers. Unless specifically stated, such quantities and numbers are not to be considered restrictive, but exemplary of the possible quantities or numbers associated with the present application. Also in this regard, the present application may use the term "plurality" to reference a quantity or number. In this regard, the term "plurality" is meant to be any number that is more than one, for example, two, three, four, five, etc. The terms "about", "approximately", "near" etc., mean plus or minus 5% of the stated value.

## Claims

1. A method of manufacturing a metal-coated workpiece (12), particularly a metal-coated electronic component, the method comprising the following steps:
- providing a substrate (22) to be coated,
- coating the substrate (22) with a first metal on at least one side of the substrate, thereby creating a mask (26) that partially covers the at least one side of the substrate (22) such that a workpiece (44) is obtained which comprises the substrate (22) and the mask (26), wherein the mask (26) comprises opaque portions (48) that are impermeable to light, thereby protecting the substrate (22), and wherein the mask comprises translucent portions (46) that are permeable to light;
- applying a light source (32) to the workpiece (44) on at least the side of the substrate (22) covered by the mask (26), wherein the light source (32) emits light (34) having a predetermined wavelength and/or a predetermined power over the entire side of the substrate (22) that is at least partially covered by the mask (26), such that apertures (50) are formed in the substrate (22) at portions not covered by the mask (26), whereas the mask (26) is left intact by the light (34); and
- coating the workpiece (44) with a second metal that at least partially covers the substrate (22) and/or the mask (26), thereby obtaining a metal-coated workpiece (12).

2. The method of claim 1, wherein the first metal and the second metal are the same metal, particularly copper.

3. The method according to any one of the preceding claims, wherein the light source (32) is a laser, particularly a CO₂-laser.

4. The method according to any one of the preceding claims, wherein the mask (26) is provided on the substrate (22) by etching a metal layer covering the substrate (22), and/or by electroforming of the mask (26) onto the substrate (22).

5. The method according to any one of the preceding claims, wherein the substrate (22) consists of a printed circuit board material.

6. The method according to any one of the preceding claims, wherein the metal-coated workpiece (12) is a lead frame or an array of lead frames.

7. The method according to any one of the preceding claims, wherein the workpiece (44) is coated with the second metal by means of a Galvanic coating process.

8. The method according to any one of the preceding claims, wherein a thickness of the mask (26) is smaller than or equal to 90% of a thickness of the substrate (22), particularly smaller than or equal to 75% of the thickness of the substrate (22), for example smaller than or equal to 60% of the thickness of the substrate (22).

9. The method according to any one of the preceding claims, wherein two masks (26, 28) are provided on opposite sides of the substrate (22), wherein the two masks (26, 28) each comprise opaque portions (48) and translucent portions (46).

10. The method according to claim 9, wherein the opaque portions (48) and the translucent portions (46) of a first one of the two masks (26) form a first pattern, wherein the opaque portions (48) and the translucent portions (46) of a second one of the two masks (28) form a second pattern, and wherein the first pattern and the second pattern are either different from each other or equal to each other.

11. The method according to any one of the preceding claims, wherein the metal-coated workpiece (12) is coated with at least a third metal at least partially, particularly wherein the third metal is different from the second metal.

12. The method according to any one of the preceding claims, wherein the metal-coated workpiece (12) comprises apertures (50) extending between opposite sides of the metal-coated workpiece (12) and/or recesses (52) on at least one side of the metal-coated workpiece (12).

13. The method according to claim 12, wherein at least one of the apertures (50) has a diameter that is smaller than a thickness of the metal-coated workpiece (12), particularly smaller than 75% of the thickness of the metal-coated workpiece (12), for example smaller than 50% of the thickness of the metal-coated workpiece (12).

14. A metal-coated workpiece obtainable by a method according to any one of the preceding claims.

15. A manufacturing system for manufacturing a metal-coated workpiece (12), particularly a metal-coated electronic component, wherein the manufacturing system (10) comprises a mask-forming device (14), an illumination device (16), and a coating device (18),
wherein the mask-forming device (14) is configured to provide a mask (26) on at least one side of a substrate (22), wherein the mask (26) consists of a first metal, wherein the mask (26) partially covers the at least one side of the substrate such that a workpiece (44) is obtained which comprises the substrate (22) and the mask (26), wherein the mask (26) comprises opaque portions (48) that are impermeable to light, thereby protecting the substrate (22), and wherein the mask (26) comprises translucent portions (46) that are permeable to light,
wherein the illumination device (16) is configured to apply a light source (32) to the workpiece (44) on at least the side of the substrate (22) covered by the mask (26), wherein the light source (32) is configured to emit light (34) having a predetermined wavelength and/or a predetermined power over the entire side of the substrate (22) that is at least partially covered by the mask (26), such that apertures (50) are formed in the substrate (22) at portions not covered by the mask (26), whereas the mask (26) is left intact by the light (34), and
wherein the coating device (18) is configured to coat the workpiece (44) with a second metal, thereby obtaining a metal-coated workpiece (12).
